# EUROPÄISCHE PATENTSCHRIFT

(11) **EP 0 891 041 B1**
(45) Veröffentlichungstag und Bekanntmachung des Hinweises auf die Patenterteilung: **03.03.2004**
(21) Anmeldenummer: 98112142.9
(22) Anmeldetag: 30.06.1998
(51) Int. Cl.: H03F 1/32

(54) **Sendeeinrichtung**
Transmission device
Dispositif émitteur

(30) Priorität: 08.07.1997 DE 19729182
(43) Veröffentlichungstag der Anmeldung: 13.01.1999
(73) Patentinhaber: SIEMENS AKTIENGESELLSCHAFT, 80333 München (DE)
(72) Erfinder: Helms, Jochen, Dr., 81673 München (DE)

(56) Entgegenhaltungen:
- EP-A- 0 706 259
- US-A- 5 162 748
- US-A- 5 524 285
- JOHANSSON M ET AL: "LINEARISATION OF RF MULTICARRIER AMPLIFIERS USING CARTESIAN FEEDBACK" ELECTRONICS LETTERS, Bd. 30, Nr. 14, 7. Juli 1994, Seiten 1110-1112, XP000459848

## Beschreibung

Die Erfindung betrifft eine Sendeeinrichtung für mehrere Träger eines breitbandigen Sendespektrums.

Eine solche Sendeeinrichtung wird vorteilhafterweise in Funkstationen innerhalb von Mobilfunknetzen verwendet, bei denen auf mehreren Trägern mit Hilfe hochfrequenter Signale eine Übertragung von Informationen zu weiteren Funkstationen erfolgt. Diese Funkstationen sind beispielsweise Basisstationen, die ortsfest sind und eine Informationsübertragung zu Mobilstationen vornehmen. In einer Sendeeinrichtung sind Eingangssignale in leistungsstärkere Ausgangssignale zu verstärken und in eine entsprechende Sendefrequenz zu konvertieren.

Soll ein breitbandiges Sendespektrum mit mehreren Trägern verstärkt werden, treten Linearitätsprobleme der Verstärkung auf. Um den Wirkungsgrad der Leistungsverstärker innerhalb der Sendeeinrichtung auf hochen Werten zu halten, werden diese üblicherweise im AB-, B- oder C-Betrieb betrieben. Diese Betriebsarten zeichnen sich jedoch durch stark nichtlineares Verhalten aus, welches eine schlechte Intermodulationsunterdrückung zur Folge hat. Ohne geeignete Linearisierungsverfahren sind solche Leistungsverstärker innerhalb von Sendeeinrichtungen mit mehreren Trägern nicht geeignet, wenn eine Mindest-Intermodulationsunterdrückung gefordert wird.

Es ist allgemein bekannt, jeden Träger individuell zu verstärken und dabei die Linearistät zu wahren. Damit ist die Sendeeinrichtung jedoch nicht breitbandig und muß entsprechend häufig in der Funkstation bereitgestellt werden. Am Verstärker-Ausgang erfolgt bei der trägerindividuellen Verstärkung ein Zusammenführen der Träger mittels Hybriden, Filtern oder Antennen. Die einzelnen Verstärkerzweige werden durch Isolatoren gegeneinander geschirmt. Harmonische Verzerrungen werden durch Sendefilter unterdrückt.

Aus US 5 524 285 ist eine Sendeeinrichtung bekannt, die einen Leistungsverstärker zum Verstärken eines Eingangssignals in ein leistungsstärkeres Ausgangssignal aufweist. Aus dem Ausgangssignal wird ein Messsignal ausgekoppelt, das in einer Mikroprozessorsteuerung mit dem Eingangssignal verglichen wird und, aus dem mit Hilfe einer Nachschlagetabelle ein Korrektursignal zur Ansteuerung eines Vorverzerrers, der das Eingangssignal vorverzerrt, abgeleitet wird.

Aus K.J.Parson, P.B.Kenington, "The efficiency of a feedforward amplifier with delay loss", IEEE Trans. on Vehicular Techn., Vol. 43, Mai 1994, Seiten 407-412, ist es bekannt, die Linearisierung eines breitbandigen Sendespektrums für mehrere Träger mit Hilfe eines "feed forward"-Verfahrens durchzuführen. Dabei wird eine Schleife aus einem Hauptverstärker und einem Fehlerverstärker aufgebaut. Der Fehlerverstärker verstärkt nur die Intermodulationsverzerrungen des Hauptverstärkers, die anschließend vom Ausgangssignal des Hauptverstärkers subtrahiert werden. Die Nachteile dieses Verfahrens sind die erforderliche analoge Abstimmgenauigkeit in Betrag und Phase an den Summationspunkten und ein geringer Wirkungsgrad, der aus der Verwendung zweier Verstärker und den Verlusten von Kopplern und Laufzeitgliedern resultiert. Zur Zeit erreicht jedoch nur dieses Verfahren in einer Doppel-Schleifen-Ausführung näherungsweise die vom GSM (Global System for Mobile Communication) Mobilfunksystem geforderten Intermodulationsunterdrückungen.

Der Erfindung liegt folglich die Aufgabe zugrunde, eine Sendeeinrichtung für mehrere Träger eines breitbandigen Sendespektrums anzugeben, die einen höheren Wirkungsgrad hat. Diese Aufgabe wird durch die Sendeeinrichtung mit den Merkmalen des Patentanspruchs 1 gelöst. Vorteilhafte Weiterbildungen der Erfindung sind den Unteransprüchen zu entnehmen.

Erfindungsgemäß enthält die Sendeeinrichtung für mehrere Träger eines breitbandigen Sendespektrums einen die Träger umfassenden, breitbandigen Leistungsverstärker zum Verstärken eines Eingangssignals in ein leistungsstärkeres Ausgangssignal, wobei mit Hilfe einer Auskoppeleinrichtung aus dem Ausgangssignal ein Meßsignal gebildet wird. Weiterhin enthält die Sendeeinrichtung eine Adaptationseinheit zum Vergleichen von Eingangssignalen und Meßsignalen sowie zum Bilden eines Korrektursignals. In einer ebenfalls zur Sendeeinrichtung gehörigen Vorverzerrereinheit wird entsprechend der Vorgaben des Korrektursignals eine Vorverzerrung des Eingangssignals vorgenommen.

Durch diese Linearisierung der Multiträger-Sendeeinrichtung mit Hilfe adaptiver Vorverzerrung wird das Eingangssignal zur Kompensation der Nichtlinearitäten des nachfolgenden Leistungsverstärkers und weiterer Einheiten vorverzerrt. Bei einem breitbandigen Sendespektrum mit mehreren Trägern entstehen bei der Modulation Intermodulationsprodukte, die durch die adaptive Vorverzerrung unterdrückt werden können. Zusätzliche Verluste ist dabei gering und der Wirkungsgrad der Sendeeinrichtung ist größer als bei einer trägerbezogenen Verstärkung.

Anders als bei Modulationsverfahren mit konstanter Einhüllender, wie z.B. die GMSK-Modulation für GSM-Mobilfunknetze, die für die Einträgerverstärkung keine linearen Verstärker benötigen, stellen diese Intermodulationsprodukte bei einem Sendesprektrum mit mehreren Trägern ein zusätzliches Problem für die Sendeeinrichtung dar, das durch die Erfindung auf wirtschaftliche Weise gelöst werden kann.

Dabei besteht die Vorverzerrereinheit aus trägerbezogenen Vorverzerrereinheiten, die auf Eingangssignale der einzelnen Träger wirken, welche anschließend zum Eingangssignal zusammengefaßt werden. Damit kann jeder Träger einzeln vorverzerrt werden, woraus sich eine sehr große Flexibilität bei der Vorverzerrung ergibt.

Vorteilhafterweise sind diese trägerbezogenen Vorverzerrereinheiten für eine digitale Signalverarbeitung ausgebildet, so daß digitalisierte trägerbezogene Eingangssignale verarbeitet werden können. Damit sind keine weiteren analogen Schaltungselemente zur Vorverzerrung nötig und das Korrektursignal bzw. die Korrektursignale können auf einfache Weise berechnet werden.

Nach einer weiteren Ausgestaltung der Erfindung wirken die trägerbezogenen Vorverzerrereinheiten auf eine In-Phase- und eine Quadratur-Komponente von digitalisierten trägerbezogenen Eingangssignalen. Die Sendeeinrichtung umfaßt dabei zusätzlich eine digitale Aufwärtskonvertiereinheit, die die vorverzerrten trägerbezogenen Eingangssignale vor dem Zusammenfassen zum Eingangssignal in eine Zwischenfrequenz konvertiert. Damit kann die Vorverzerrung im Basisband stattfinden und benötigt keine hochfrequenten Baugruppen.

Weiterhin ist es vorteilhaft, mit einem Analog/Digital-Wandler das Meßsignal zu digitalisieren und der Adaptationseinrichtung zuzuführen. Damit kann auch die Adaptationseinheit als digitale Signalverarbeitungseinrichtung ausgeprägt sein. Korrespondierend zur Aufwärtskonvertiereinheit kann vorteilhafterweise eine Abwärtskonvertiereinheit vorgesehen sein, die das digitalisierte Meßsignal zum Weiterverarbeiten in der Adaptationseinheit ins Basisband konvertiert.

Die digitale Signalverarbeitung in der Adaptationseinheit wird weiterhin erleichtert, wenn korrespondierend zu den trägerbezogenen Eingangssignalen auch das Meßsignal in trägerbezogene digitale Meßsignale umgewandelt wird; beispielsweise durch eine digitale Abwärtskonvertiereinheit, die trägerbezogen aufgebaut ist. Durch eine solche Ausprägung der erfindungsgemäßen Sendeeinrichtung ist eine vollständige digitale Verarbeitung und Vorverzerrung möglich. Diese Ausprägung hat weiterhin den Vorteil, daß die Nichtlinearitäten einiger Baugruppen zusätzlich zur Nichtlinearität des Leistungsverstärkers moduliert und mit Hilfe der Vorverzerrereinheit ausgeglichen werden können. Der Fehler des Rückführungszweigs mit dem Meßsignal sollte jedoch bekannt sein.

Nach einer weiteren Ausprägung der Erfindung enthält die Sendeeinrichtung eine Speichereinrichtung zum Speichern des durch die Adaptationseinheit bestimmten Korrektursignals, das für ein nachfolgendes Eingangssignal verwendet wird. Eine Funkübertragung erfolgt oftmals in Funkblöcken, beispielsweise beim TDMA- (Time Division Multiple Access) Zugriffsverfahren. Nach der Auswertung eines Funkblockes und den bestimmten Nichtlinearitäten wird das Korrektursignal auf das nachfolgende Eingangssignal, d.h. nachfolgende Symbole oder den nachfolgenden Funkblock, angewendet. Damit ist eine ständige Nachführung der Vorverzerrung möglich.

Eine Speichereinrichtung kann weiterhin zum Speichern von bestimmten Intermodulationsprodukten von in der Sendeeinrichtung vorhandenen Frequenzen eingesetzt werden. Da alle im System vorhandenen Frequenzen (Trägerfrequenzen und Takte) bekannt sind (im Gegensatz zu Breitbandempfängern), lassen sich die Lage und Ordnung der auftretenden Intermodulationsverzerrungen vorab berechnen. Auf diese vorhersehbaren Intermodulationsverzerrungen kann darauffolgend die Vorverzerrung konzentriert werden. Bestimmte Intermodulationsprodukte können der Adaptationseinheit als Adaptationskriterien für die Vorverzerrung dienen.

Durch die geschilderte Sendeeinrichtung wird ein höherer Wirkungsgrad erreicht und durch die weitreichende Digitalisierung ist der Aufwand zum Abgleich der analogen Schaltung relativ gering. Die wesentlichen Nichtlinearitäten des Sendepfades werden summarisch kompensiert. Eine Aufteilung und damit eine Verschärfung der Gesamtanforderung bezüglich der Intermodulationsunterdrückung ist nicht erforderlich. Der höhere Aufwand bei der digitalen Signalverarbeitung und Speicherung fällt durch den zu erwartenden technologischen Fortschritt und den Preisverfall für diese Technologien weniger ins Gewicht.

Anhand von Ausführungsbeispielen, die auf die Figuren Bezug nehmen, wird die Erfindung näher erläutert.

Dabei zeigen
- Figur 1: ein Blockschaltbild der Funkübertragung zwischen einer Basisstation und Mobilstationen,
- Figur 2: eine schematische Darstellung der Aufteilung des breitbandigen Spektrums,
- Figur 3: ein Blockschaltbild einer Sendeeinrichtung, und
- Figur 4: ein detaillierteres Blockschaltbild einer Sendeeinrichtung.

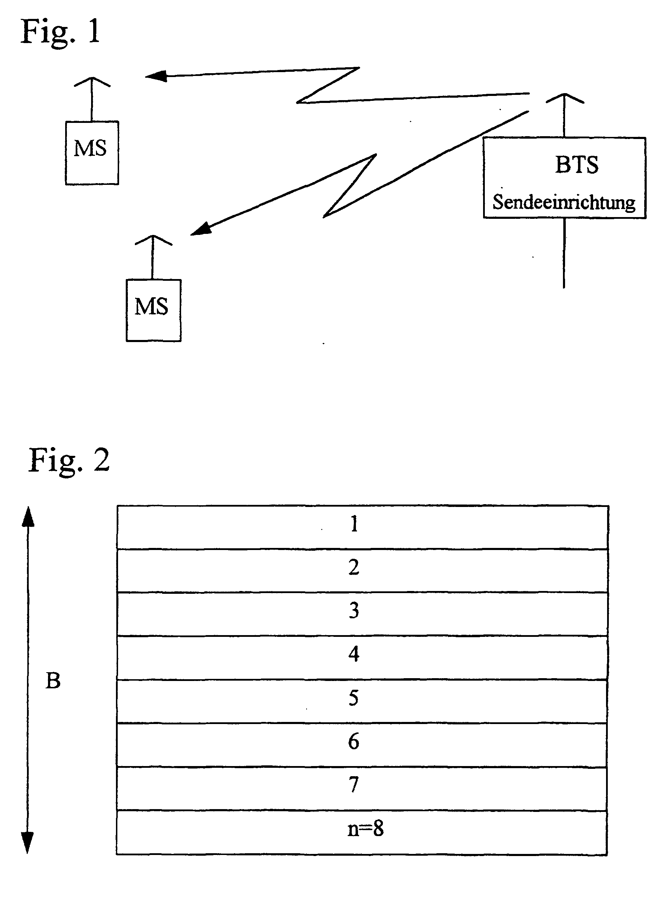

FIG 1 zeigt die Informationsübertragung von einer sendenden Basisstation BTS zu Mobilstationen MS. Die Basisstation BTS enthält eine Sendeeinrichtung, die ein breitbandiges Sendesignal erzeugt. Das breitbandige Sendesignal umfaßt ein Spektrum B, beispielsweise B = 1,6 MHz, in dem mehrere Träger 1, 2,..,n=8 (siehe FIG 2) gleichzeitig enthalten sind. Damit können z.B. zwei Mobilstationen MS gleichzeitig auf verschiedenen Trägern bedient werden.

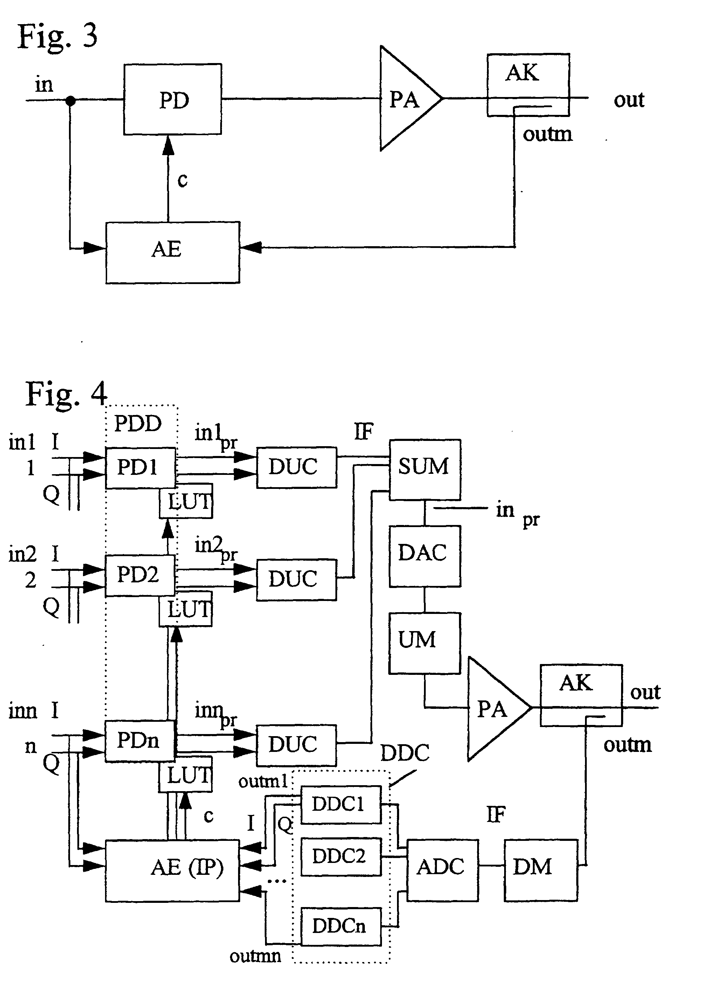

FIG 3 zeigt ein Blockschaltbild der Sendeeinrichtung, die eine Vorverzerrereinheit PD, einen Leistungsverstärker PA, eine Auskoppeleinrichtung AK und eine Adaptationseinheit AE enthält.

Ein Eingangssignal in wird der Vorverzerrereinheit PD und der Adaptationseinheit AE zugeführt. Die Vorverzerrereinheit PD nimmt eine Vorverzerrung des Eingangssignals in vor, wobei dabei Vorgaben eines Korrektursignals c, das von der Adaptationseinheit AE erzeugt wird, beachtet werden. Das vorverzerrte Eingangssignal wird im Leistungsverstärker PA verstärkt, wobei die Verzerrung des Leistungsverstärkers PA durch die Vorverzerrung vorweggenommen und durch entsprechende Korrekturen ausgeglichen wurden. Verfahren zur digitalen Entzerrung sind beispielsweise aus L.Sundström et al, "Quantization analysis and design of a digital predistortion linearizer for RF power amplifiers", IEEE Trans. on Vehicular Technol., Vol. 45, November 1996, S.707-719, bekannt, jedoch nur für eine Trägerfrequenz, ohne Berücksichtigung von Intermodulationsstörungen.

Am Ausgang des Leistungsverstärkers PA liegt ein Ausgangssignal out vor. Mit Hilfe der Auskoppeleinrichtung AK wird aus dem Ausgangssignal out ein Meßsignal outm erzeugt. Die Auskoppeleinrichtung AK ist beispielsweise als Richtkoppler ausgeprägt, die einen geringen Teil der Sendeleistung auskoppelt.

Das Meßsignal outm wird zusätzlich zum Eingangssignal in in der Adaptationseinrichtung AE ausgewertet. In der Adaptationseinrichtung AE wird ein Vergleich des Eingangssignals in mit dem Messignal outm durchgeführt, woraus sich die Verzerrungen durch den Leistungsverstärker PA und andere Baugruppen ableiten lassen. Zum Ausgleich dieser Verzerrungen wird ein Korrektursignal c gebildet, das durch die Vorverzerrereinheit PD ausgewertet wird und deren Vorverzerrung einstellt.

FIG 4 zeigt die Sendeeinrichtung detaillierter, wobei das Eingangssignal der Sendeeinrichtung aus trägerbezogenen Eingangssignalen in1, in2,...,inn besteht. Diese trägerbezogenen Eingangssignale in1 bis inn sind digitalisiert und bestehen folglich aus einer In-Phase-Komponente I und einer Quadratur-Komponente Q. Die trägerbezogenen Eingangssignale in1 bis inn sind dabei den Trägern 1 bis n nach FIG 2 zugeordnet.

Auch die Vorverzerrereinheit PD ist trägerbezogen in trägerbezogenen Vorverzerrereinheiten PD1, PD2,..., PDn aufgebaut, welche die Eingangssignale in1 bis inn verarbeiten. Die Vorverzerrung der Eingangssignale in1 bis inn wird entsprechend der Vorgaben einer Speichereinrichtung LUT eingestellt.

Jeder trägerbezogenen Vorverzerrereinheit PD1, PD2,..., PDn ist eine solche Speichereinrichtung LUT zugeordnet. Es ist alternativ auch möglich, eine zentrale Speichereinrichtung LUT vorzusehen. In den Speichereinrichtungen LUT sind die Werte der trägerindividuellen Korrektursignale c gespeichert. Nach den Vorgaben der Korrektursignale c erfolgt die Vorverzerrung in vorverzerrte Eingangssignale in1ₚᵣ, in2ₚᵣ,..., innₚᵣ. Dies sind weiterhin digitalisierte Signale, die daraufhin trägerbezogenen digitalen Aufwärtskonvertiereinheiten DUC zugeführt werden.

Diese digitalen Aufwärtskonvertiereinheiten DUC nehmen eine Umsetzung auf eine digitale Zwischenfrequenz IF vor. Anschließend werden die digitalen Datenströme der Zwischenfrequenz IF in einer Summiereinrichtung SUM summiert zum vorverzerrten Eingangssignal inₚᵣ. Ein darauffolgender Digital/Analog-Wandler DAC wandelt das Signal der Zwischenfrequenz IF in ein analoges Signal um, das anschließend in einem Aufwärtsmischer UM moduliert und in die Sendefrequenz umgewandelt wird. Vor und nach dem Aufwärtsmischer UM werden - nicht dargestellte - Bandfilter eingesetzt, die das entsprechende Frequenzband begrenzen. Dieses Signal wird daraufhin dem Leistungsverstärker PA zugeführt, der eine Leistungsverstärkung vornimmt und das Ausgangssignal out ausgibt.

Wie bereits geschildert, nimmt die Auskoppeleinrichtung AK ein Auskoppeln eines Messignals outm aus dem Ausgangssignal out vor, wobei das Meßsignal outm einem Abwärtsmischer DM zugeführt wird, der korrespondierend zum Aufwärtsmischer UM das Meßsignal outm in die Zwischenfrequenz konvertiert und bandfiltert. Auch hierbei kommen vorteilhafterweise Bandfilter vor und nach dem Abwärtsmischer DM zum Einsatz. Es schließt sich eine Analog/Digital-Wandlung in einem Analog/ Digital-Wandler ADC an.

Das Meßsignal outm wird daraufhin von Abwärtskonvertiereinheiten DDC1, DDC2,...,DDCn verarbeitet. Diese Abwärtskonvertiereinheiten DDC1, DDC2,..., DDCn setzen geeignete Intermodulationsprodukte bzw. Träger ins komplexe Basisband um und stellen trägerbezogene bzw. intermodulationsbezogene Meßsignale outml bis outmn der Adaptationseinheit AE zur Verfügung. Die Adaptationseinheit AE berechnet anhand eines Vergleichs der Eingangssignale in1 bis inn und der Meßsignale outm1 bis outmn Korrektursignale, die als Korrekturdaten c an die Speichereinrichtungen LUT ausgegeben werden. Die bei der Auswertung von verarbeiteten Symbolen eines Funkblockes bestimmten Korrekturdaten c werden daraufhin bei der Verstärkung von darauffolgenden Symbolen zur Vorverzerrung eingesetzt. Die Korrekturdaten c sind dabei möglichst aktuell.

Falls die Bandbreite der verfügbaren Komponenten nicht ausreicht, um die gewünschte Gesamtbandbreite (z.B. E-GSM: 35 MHz) abzudecken, wird das Gesamtband in Teilbänder unterteilt. Pro Teilband ist dann das Blockschaltbild nach FIG 4 anzuwenden.

Durch die Verwendung von digitalen Aufwärts- und Abwärtsmischern UM, DM werden Amplituden- und Gleichspannungsoffset-Fehler vermieden. Damit wird die Adaptation durch diese Fehler nicht verfälscht. Durch die summarische Modellierung der Nichtlinearitäten im Sendepfad, nicht nur des Leistungsverstärkers PA, sondern auch der übrigen Baugruppen DUC, SUM, DAC und UM, kann eine sehr gute Linearität bei trotzdem hohem Wirkungsgrad erreicht werden. Durch die Auswahl geeigneter Intermodulationsprodukte IP, die durch die Adaptationseinrichtung AE berücksichtigt werden, stehen Adaptationskriterien für die Vorverzerrung zur Verfügung. Da die im System benutzten Frequenzen bekannt sind, können die Intermodulationsprodukte IP vorab festgelegt werden.

## Patentansprüche

1. Sendeeinrichtung für mehrere Träger (1, 2,..n) eines breitbandigen Sendespektrums, mit
- einem die Träger (1, 2,..n) umfassenden, breitbandigen Leistungsverstärker (PA) zum Verstärken eines Eingangssignals (in) in ein leistungsstärkeres Ausgangssignals (out),
- einer Auskoppeleinrichtung (AK) zum Bilden eines Meßsignals (outm) aus dem Ausgangssignal (out),
- einer Adaptationseinheit (AE) zum Vergleichen von Eingangssignal (in) und Meßsignal (outm) sowie zum Bilden eines Korrektursignals (c),
- einer Vorverzerrereinheit (PD) zum Vorverzerren des Eingangssignals (in) entsprechend der Vorgaben des Korrektursignals (c), wobei die Vorverzerrereinheit (PD) trägerbezogene Vorverzerrereinheiten (PD1, PD2,..PDn) aufweist, die auf anschließend zum Eingangssignal (in) zusammengefaßte trägerbezogene Eingangssignale (in1, in2,.., inn) wirken.

2. Sendeeinrichtung nach Anspruch 1, bei der
die trägerbezogenen Vorverzerrereinheiten (PD1, PD2,..PDn) eine digitale Signalverarbeitung von digitalisierten trägerbezogenen Eingangssignalen (in1, in2,.., inn) vornehmen.

3. Sendeeinrichtung nach Anspruch 1 oder 2, mit trägerbezogenen Vorverzerrereinheiten (PD1, PD2,..PDn), die auf In-Phase und Quadratur-Komponente von digitalisierten trägerbezogene Eingangssignalen (in1, in2,.., inn) wirken, und mit einer digitalen Aufwärtskonvertiereinheit (DUC), die die vorverzerrten trägerbezogenen Eingangssignale (in1ₚᵣ, in2ₚᵣ, .., innₚᵣ) vor einem Zusammenfassen zum Eingangssignal (in) in eine Zwischenfrequenz (IF) konvertiert.

4. Sendeeinrichtung nach einem der vorhergehenden Ansprüche, mit einem Analog/Digital-Wandler (ADC) zum Digitalisieren des Meßsignals (outm).

5. Sendeeinrichtung nach Anspruch 4,
mit einer digitalen Abwärtskonvertiereinheit (DDC) für das digitalisierte Meßsignal (outm) zum Weiterverarbeiten in der Adaptationseinheit (AE).

6. Sendeeinrichtung nach Anspruch 5, bei der
die digitale Abwärtskonvertiereinheit (DDC1, DDC2,..DDCn) trägerbezogen und/oder bezogen auf Intermodulationsprodukte (IP) aufgebaut ist und trägerbezogene und/oder intermodulationsproduktbezogene digitale Meßsignale (outm1, outm2, .., outmn) ausgibt.

7. Sendeeinrichtung nach einem der vorhergehenden Ansprüche, mit einer Speichereinrichtung (LUT) zum Speichern des durch die Adaptationseinheit (AE) bestimmten Korrektursignals (c), das für ein nachfolgendes Eingangssignal (in) angewendet wird.

8. Sendeeinrichtung nach einem der vorhergehenden Ansprüche, mit einer Speichereinrichtung (LUT) zum Speichern von Intermodulationsprodukten (IP) von in der Sendeeinrichtung vorhandenen Frequenzen.

9. Sendeeinrichtung nach Anspruch 8, bei der
durch die Adaptationseinheit (AE) bestimmte Intermodulationsprodukte (IP) als Adaptatiönskriterium verwendet werden.

## Claims

1. Transmission device for several carriers (1, 2,..n) in a broadband spectrum, with
- a broadband power amplifier (PA) which covers the carriers (1, 2,..n), for amplifying an input signal (in) into a more powerful output signal (out),
- a tapping device (AK) for obtaining a monitoring signal (outm) from the output signal (out),
- an adaptation unit (AE) for comparing the input signal (in) and the monitoring signal (outm) and for generating a correction signal (c),
- a predistortion unit (PD) for predistorting the input signal (in) appropriately for the data in the correction signal (c), where the predistortion unit (PD) has carrier-specific predistortion units (PD1, PD2,..PDn), which process carrier-specific input signals (in1, in2,.., inn) which are then combined to form the input signal (in).

2. Transmission device in accordance with claim 1, in which the carrier-specific predistortion units (PD1, PD2,..PDn) apply digital signal processing to digitized carrier-specific input signals (in1, in2,.., inn).

3. Transmission device in accordance with claim 1 or 2, with carrier-specific predistortion units (PD1, PD2,..PDn) which process the in-phase and quadrature components of digitized carrier-specific input signals (in1, in2,.., inn), and with a digital upward conversion unit (DUC) which converts the predistorted carrier-specific input signals (in1ₚᵣ, in2ₚᵣ, .., innₚᵣ) to an intermediate frequency (IF) before they are combined to form the input signal (in).

4. Transmission device in accordance with one of the preceding claims, with an analog/digital converter (ADC) for digitizing the monitoring signal (outm).

5. Transmission device in accordance with claim 4,
with a digital downward conversion unit (DDC) for the digitized monitoring signal (outm), for its further processing in the adaptation unit (AE).

6. Transmission device in accordance with claim 5, in which the design of the digital downward conversion unit (DDC1, DDC2,..DDCn) is carrier-specific and/or specific to intermodulation products (IP), and which outputs digital monitoring signals (outm1, outm2,.., outmn) which are carrier-specific and/or specific to intermodulation products.

7. Transmission device in accordance with one of the preceding claims,
with a storage device (LUT) for storing the correction signal (c) determined by the adaptation unit (AE), to be used as a subsequent input signal (in).

8. Transmission device in accordance with one of the preceding claims,
with a storage device (LUT) for storing intermodulation products (IP) produced by the frequencies present in the transmission device.

9. Transmission device in accordance with claim 8, in which intermodulation products (IP) determined by the adaptation unit (AE) are used as the adaptation criterion.

## Revendications

1. Dispositif émetteur pour plusieurs porteuses (1, 2, ..., n) d'un spectre d'émission à large bande, comprenant
- un amplificateur de puissance (PA) à large bande contenant les porteuses (1, 2, ..., n) qui sert à amplifier un signal d'entrée (in) pour obtenir un signal de sortie (out) plus puissant,
- un dispositif de découplage (AK) servant à former un signal de mesure (outm) à partir du signal de sortie (out),
- une unité d'adaptation (AE) servant à comparer le signal d'entrée (in) et le signal de mesure (outm) et à former un signal de correction (c),
- une unité de pré-distorsion (PD) servant à la pré-distorsion du signal d'entrée (in) conformément aux caractéristiques prédéfinies du signal de correction (c), l'unité de pré-distorsion (PD) comprenant des unités de pré-distorsion relatives aux porteuses (PD1, PD2, ..., PDn) qui agissent sur des signaux d'entrée relatifs aux porteuses (in1, in2, ..., inn) réunis par la suite pour former le signal d'entrée (in).

2. Dispositif émetteur selon la revendication 1, dans lequel les unités de pré-distorsion relatives aux porteuses (PD1, PD2, ..., PDn) procèdent à un traitement numérique des signaux d'entrée relatifs aux porteuses (in1, in2, ..., inn) numérisés.

3. Dispositif émetteur selon la revendication 1 ou 2, comprenant des unités de pré-distorsion relatives aux porteuses (PD1, PD2, ..., PDn) qui agissent sur les composantes en phase et en quadrature de signaux d'entrée relatifs aux porteuses (in1, in2, ..., inn) numérisés et comprenant une unité de conversion numérique vers le haut (DUC) qui convertit les signaux d'entrée relatifs aux porteuses pré-distordus (in1ₚᵣ, in2ₚᵣ, ..., innₚᵣ) en une fréquence intermédiaire (IF) avant qu'ils soient réunis pour former le signal d'entrée (in).

4. Dispositif émetteur selon l'une des revendications précédentes, comprenant un convertisseur analogique-numérique (ADC) servant à numériser le signal de mesure (outm).

5. Dispositif émetteur selon la revendication 4, comprenant une unité de conversion numérique vers le bas (DDC) pour le signal de mesure numérisé (outm) en vue de son traitement ultérieur dans l'unité d'adaptation (AE).

6. Dispositif émetteur selon la revendication 5, dans lequel l'unité de conversion numérique vers le bas (DDC1, DDC2, ..., DDCn) est construite de manière à correspondre aux porteuses et/ou en rapport avec des produits d'intermodulation (IP) et délivre des signaux de mesure numériques (outm1, outm2, ..., outmn) relatifs aux porteuses et/ou relatifs aux produits d'intermodulation.

7. Dispositif émetteur selon l'une des revendications précédentes, comprenant un dispositif d'enregistrement (LUT) pour enregistrer le signal de correction (c) déterminé par l'unité d'adaptation (AE) qui est utilisé pour un signal d'entrée subséquent (in).

8. Dispositif émetteur selon l'une des revendications précédentes, comprenant un dispositif d'enregistrement (LUT) pour enregistrer des produits d'intermodulation (IP) de fréquences présentes dans le dispositif émetteur.

9. Dispositif émetteur selon la revendication 8, dans lequel des produits d'intermodulation (IP) déterminés par l'unité d'adaptation (AE) sont utilisés en tant que critères d'adaptation.
